# EUROPÄISCHE PATENTANMELDUNG

(11) **EP 0 729 034 A2**
(43) Veröffentlichungstag der Anmeldung: **28.08.1996**
(21) Anmeldenummer: 96101352.1
(22) Anmeldetag: 31.01.1996
(51) Int. Cl.: G01R 31/28

(54) **Prüfschaltung und Prüfverfahren zur Funktionsprüfung von elektronischen Schaltungen**

(30) Priorität: 23.02.1995 DE 19506325
(71) Anmelder: SIEMENS AKTIENGESELLSCHAFT, 80333 München (DE)
(72) Erfinder: Nikutta, Wolfgang, Dipl.-Phys., D-81541 München (DE); von der Ropp, Thomas, Dr. Dipl.-Phys., D-82110 Germering (DE); Schmökel, Hartmut, Dipl.-Ing., D-85521 Ottobrunn (DE); Walter, Rudolph, Dipl.-Ing., Plano, Texas (US); Kuchinke, Günther, Dipl-Ing., D-85579 Neubiberg (DE)

(57) **Zusammenfassung**

Prüfschaltung und Prüfverfahren zur Funktionsprüfung von elektronischen Schaltungen (31) mit Ausgängen (1), bei welcher wenigstens zwei Widerstandselemente (21) einen gemeinsamen Schaltungsknoten (3) aufweisen, welcher mit einem Anschluß (2) einer Testeranordnung (32) verbindbar ist und bei der vom Schaltungsknoten (3) abgewandte Anschlüsse (4) der Widerstandselemente (21) mit jeweils einem der Ausgänge (1) verbindbar sind.

## Beschreibung

Die Erfindung betrifft eine Prüfschaltung und ein Prüfverfahren zur Funktionsprüfung von elektronischen Schaltungen mit Ausgängen.

Die Prüfung elektronischer Schaltungen auf Fehlerfreiheit ist eine sich häufig stellende Aufgabe. Insbesondere im Anschluß an den Herstellungsprozeß der Schaltungen werden derartige Prüfungen oftmals durchgeführt. In manchen Fällen ist es wünschenswert, die Prüfung darauf zu beschränken, die elektronische Schaltung in einen definierten Zustand zu versetzen und anschließend lediglich die Signale an ihren Ausgängen zu betrachten und mit den bei ordnungsgemäßer Funktion der Schaltung zu erfüllenden Grenz- bzw. Sollwerten zu vergleichen. Daraufhin ist - je nach Art der elektronischen Schaltung - eine mehr oder weniger gesicherte Aussage über die einwandfreie Funktion der gesamten Schaltung möglich.

Beispielsweise werden integrierte Speicherbausteine, z.B. RAMs, herstellerseitig einer derartigen Funktionsprüfung unterzogen. Dabei wird jeder Ausgang der zu testenden Speicherbausteine mit jeweils einem Anschluß einer die Prüfung durchführenden Testeranordnung verbunden. Anschließend beschreibt die Testeranordnung die Speicherzellen des Speicherbausteines und liest sie wieder aus. Auf diese Weise sind Fehlfunktionen der geprüften Schaltung feststellbar.

Beim Testen von elektronischen Schaltungen nach dem beschriebenen Stand der Technik ergibt sich bei einer gegebenen Anzahl von Anschlüssen der Testeranordnung eine Beschränkung der Testkapazität: Mit einer Testeranordnung ist eine Schaltung nur dann vollständig bzw. sind mehrere Schaltungen lediglich dann gleichzeitig testbar, wenn die gesamte Anzahl der zu prüfenden Ausgänge die Anzahl der entsprechenden Anschlüsse der Testeranordnung nicht überschreitet. Eine Vergrößerung der Testkapazität ist nur durch den Einsatz einer Testeranordnung mit einer größeren Anzahl von entsprechenden Anschlüssen oder von zusätzlichen Testeranordnungen möglich.

Der vorliegenden Erfindung liegt die Aufgabe zugrunde, eine Prüfschaltung und ein Prüfverfahren der obengenannten Art zu finden, bei dem die Testkapazität erhöht und somit der maximale Durchsatz von zu prüfenden Schaltungen bei einer gegebenen Anzahl von Anschlüssen der Testeranordnung erhöht wird, die genannten Nachteile jedoch vermieden werden.

Diese Aufgabe wird durch eine Prüfschaltung gemäß Anspruch 1 und ein Prüfverfahren gemäß Anspruch 10 gelöst.

Indem Ausgänge einer oder mehrerer elektronischer Schaltungen über Widerstandselemente mit einem gemeinsamen Schaltungsknoten und dieser mit einem Anschluß einer Testeranordnung verbindbar sind, ist eine größere Anzahl von Ausgängen mit derselben Testeranordnung gleichzeitig prüfbar. Wenn beispielsweise jeweils immer zwei Ausgänge der zu prüfenden Schaltungen über Widerstandselemente mit der Testeranordnung verbunden werden, ergibt sich bereits eine Verdopplung der Testkapazität, womit eine Verdopplung des Testdurchsatzes möglich ist. Auf diese Weise lassen sich Investitionskosten für Testeranordnungen reduzieren.

Vorteilhafte Weiterbildungen der Erfindung sind in den Unteransprüchen gekennzeichnet.

Die verwendeten Widerstandselemente können aktive Widerstände (beispielsweise als Widerstände verbundene Transistorelemente wie Transistoren oder Thyristoren) oder passive Widerstände (beispielsweise ohmsche Widerstände) enthalten.

Sind für den Testfall zum Bewertungszeitpunkt die zu erwartenden Ausgangssignale an den Ausgängen der zu testenden Schaltungen ihren Grenzwerten (Potential, Stromstärke, Signalform) nach bekannt, kann durch entsprechende Dimensionierung der Widerstandselemente ein bezüglich der obengenannten Grenzwerte relativer Grenzwert für das sich am gemeinsamen Schaltungsknoten (und damit am entsprechenden Anschluß der Testeranordnung) einstellende, resultierende Signal zum Bewertungszeitpunkt vorgegeben werden. Die Vorgabe dieses relativen Grenzwertes kann außerdem durch Hinzufügen weiterer Widerstandselemente zwischen den mit der Testeranordnung verbundenen Schaltungsknoten und ein festes Potential, beispielsweise Masse, erfolgen. Bei Über- bzw. Unterschreiten des relativen Grenzwertes stellt die Testeranordnung einen Fehler der geprüften Schaltung fest.

Besonders vorteilhaft ist es, wenn herkömmliche Testeranordnungen eingesetzt und die Prüfschaltung zwischen die zu prüfende elektronische Schaltung und die Testeranordnung eingefügt wird, beispielsweise in einem Verbindungskabel zwischen Speicherelement und Testeranordnung oder auf einem schon bisher zum Testen verwendeten Testsockel bzw. einer Steckplatine. Auf diese Weise ist der Aufwand am geringsten und eine spätere Änderung der Prüfschaltung ist besonders leicht möglich. Andererseits ist durch geringfügige konstruktive Änderungen an der Testeranordnung oder der zu testenden Schaltung auch dort eine Anordnung der Widerstandselemente möglich.

Die Erfindung eignet sich sowohl zur Prüfung analoger als auch digitaler Schaltungen. Sie eignet sich besonders gut zur Prüfung von gleichartigen Ausgängen und von integrierten Schaltungen, welche Bereiche mit Speichern mit wahlfreiem Zugriff (SRAM, DRAM, FRAM) oder mit nicht-flüchtigen Speichern (EPROM) aufweisen. Ferner können die Ausgänge der zu prüfenden Schaltung bidirektional sein (Input-/Output-Anschlüsse).

Werden Widerstandselemente mit gemeinsamem Schaltungsknoten verwendet, die gleiche Widerstandswerte aufweisen, ist bei gleichartigen Ausgängen die gleiche Prüfschärfe (Genauigkeit der Prüfung) erzielbar wie bei Prüfung einzelner Ausgänge ohne die erfindungsgemäße Prüfschaltung.

Bei der Bestimmung der Widerstandswerte für die zu verwendenden Widerstandselemente sind die maximal zulässigen Ströme je Ausgang der zu testenden Schaltung zu berücksichtigen. Es ist möglich, daß zu Prüfzwecken in bekannter Weise neben der Prüfschaltung weitere ohmsche oder kapazitive Lasten mit den Ausgängen verbunden werden. Bei der Berechnung des maximal möglichen Stromes müssen dann außer den Strömen durch die Widerstandselemente auch die Ströme durch diese zusätzlichen Lasten Berücksichtigung finden.

Werden mit der Prüfschaltung DRAMs mit gleichartigen Ausgängen getestet, hat sich bei gemeinsamer Prüfung je zweier Ausgänge der Einsatz ohmscher Widerstandselemente von beispielsweise je 68 Ohm bewährt.

Es ist möglich, daß wenigstens eines der Widerstandselemente mit gemeinsamem Schaltungsknoten, jedoch nicht alle, ein Kurzschlußelement mit einem ohmschen Widerstand von 0 Ohm ist.

Die Prüfschaltung ermöglicht es, Ausgänge mehrerer elektronischer Schaltungen über Widerstandselemente mit einem gemeinsamen Schaltungsknoten zu verbinden, so daß sie mit einem gemeinsamen Anschluß der Testeranordnung verbindbar sind. Dabei können die zu prüfenden elektronischen Schaltungen lediglich jeweils einen Ausgang aufweisen.

Nachfolgend wird die Erfindung anhand einer Zeichnung näher beschrieben. Es zeigen
die Figuren 1 bis 3 verschiedene Ausführungsformen der Erfindung und
Figur 4 mögliche Signalverläufe an einem gemeinsamen Schaltungsknoten.

Die Figuren sind rein schematisch und auf die für die Erfindung unbedingt erforderlichen Einzelheiten beschränkt.

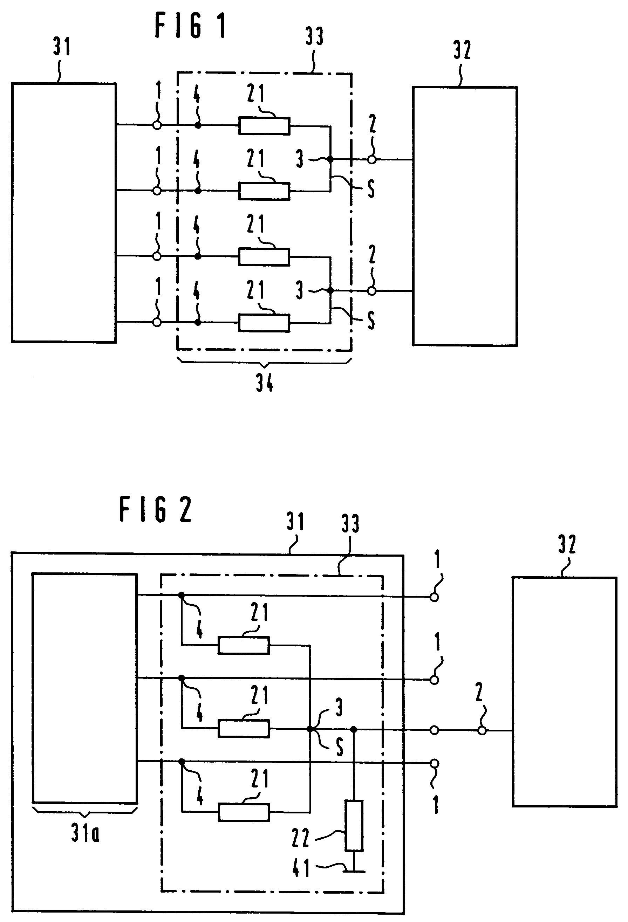

Figur 1 zeigt eine Prüfschaltung 33, welche sich auf einem Testsockel 34, einer steckbaren Platine oder ähnlichem befinden kann. Die Prüfschaltung 33 weist vier Widerstandselemente 21 auf, von denen jeweils zwei über einen Schaltungsknoten 3 miteinander verbunden sind. Für die Durchführung einer Funktionsprüfung sind die Schaltungsknoten 3 mit Anschlüssen 2 einer Testeranordnung 32 verbindbar. Die von den Schaltungsknoten 3 abgewandten Anschlüsse 4 der Widerstandselemente 21 sind mit den Ausgängen 1 einer zu prüfenden elektronischen Schaltung 31 verbindbar. Die Ausgänge 1 können gleichzeitig auch Eingänge der Schaltung 31 sein. Beim Ausführungsbeispiel in Figur 1 sind die Verbindungen zwischen der Prüfschaltung 33 und der Schaltung 31 sowie der Testeranordnung 32 hergestellt. Die Funktionsprüfung wird bezüglich eines sich an den Schaltungsknoten 3 einstellenden, resultierenden Signals S durchgeführt.

Vorteilhaft ist der Einsatz ohmscher Widerstände als Widerstandselemente 21. Es ist beispielsweise aber auch der Einsatz von als Widerstände geschalteten Transistoren möglich.

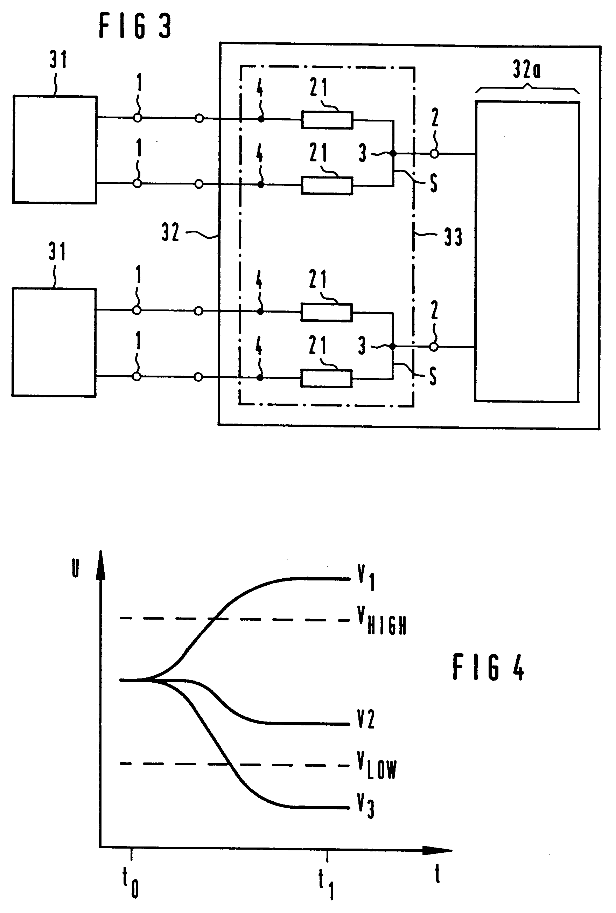

Insbesondere wenn die Ausgänge 1, welche über Widerstandselemente 21 mit einem gemeinsamen Schaltungsknoten 3 verbunden sind, zu einem Bewertungszeitpunkt t₁ (s. Fig. 4) bei ordnungsgemäß funktionierender Schaltung 31 Ausgangssignale mit im wesentlichen demselben Potential aufweisen, ist es günstig, daß die Widerstandselemente 21, welche einen gemeinsamen Schaltungsknoten 3 aufweisen, denselben Widerstandswert aufweisen. Dann stellt sich nämlich bei intakter Schaltung 31 auch am Schaltungsknoten 3 und somit am Anschluß 2 der Testeranordnung 32 ein resultierendes Signal S mit demselben Potential ein.

In Figur 2 ist die Prüfschaltung 33 Bestandteil der zu testenden elektronischen Schaltung 31. Letztere kann in integrierter Schaltungstechnik ausgeführt sein. Mit 31a ist der zu testende Teil der Schaltung 31 bezeichnet. Die Prüfschaltung 33 weist drei Widerstandselemente 21 auf, die einen gemeinsamen Schaltungsknoten 3 besitzen. Die Anschlüsse 4 der Widerstandselemente 21 sind mit je einem Ausgang der zu prüfenden elektronischen Schaltung 31 elektrisch verbunden. Der Schaltungsknoten 3 ist mit einem Anschluß 2 der Testeranordnung 32 verbindbar. Diese Verbindung ist beim Ausführungsbeispiel in Figur 2 hergestellt.

Weiterhin weist die Prüfschaltung 33 in Figur 2 ein weiteres Widerstandselement 22 auf, welches zwischen dem Schaltungsknoten 3 und einem festen Potential 41, in diesem Fall Masse, angeordnet ist. Das weitere Widerstandselement 22 bildet mit den Widerstandselementen 21 Spannungsteiler. Durch geeignete Dimensionierung der Widerstandselemente 21 und des weiteren Widerstandelementes 22 ist es möglich, einen bezüglich des Grenzwertes der Ausgangssignale an den Ausgängen 1 relativen Grenzwert für das sich am gemeinsamen Schaltungsknoten 3 (und damit am entsprechenden Anschluß 2 der Testeranordnung 32) einstellende, resultierende Signal S zum Bewertungszeitpunkt t₁ vorzugeben, auch wenn die Grenzwerte für die Ausgangssignale einzelner Ausgänge 1 voneinander abweichen.

Figur 3 zeigt ein Ausführungsbeispiel der Erfindung für das gleichzeitige Testen zweier elektronischer Schaltungen 31 mittels einer Testeranordnung 32. Die prüfschaltung 33 ist bei diesem Ausführungsbeispiel Bestandteil der Testeranordnung 32. Mit 32a ist der von der Prüfschaltung 33 verschiedene Teil der Testeranordnung 32 bezeichnet. Zwei Ausgänge 1 jeder elektronischen Schaltung 31 sind mit jeweils einem Anschluß 4 eines Widerstandelementes 21 verbindbar. Diese Verbindung wurde bei dem Ausführungsbeispiel in Figur 3 hergestellt. Die Widerstandselemente 21, welche mit derselben Schaltung 31 verbunden sind, weisen einen gemeinsamen Schaltungsknoten 3 auf. Die Schaltungsknoten 3 sind mit je einem Anschluß 2 der Testeranordnung 32 verbindbar.

Figur 4 zeigt in einer schematischen Darstellung mögliche Verläufe des resultierenden Signals S, wie es bei Durchführung der Prüfung an einem der Schaltungsknoten 3 und damit an dem mit diesem zu verbindenden Anschluß 2 einer Testeranordnung 32 auftreten kann. Dargestellt ist der Potentialverlauf U über der Zeit t. Für das zugrundeliegende Ausführungsbeispiel wird angenommen, daß es sich bei der zu prüfenden Schaltung 31 um einen integrierten Speicherbaustein, beispielsweise ein DRAM, handelt, an dessen Ausgängen 1 zum Bewertungszeitpunkt t₁ bei ordnungsgemäßer Funktion Signale mit einem Potential anliegen, welches dem logischen Eins-Zustand entspricht. Weiter wird angenommen, daß zwei Ausgänge 1 des Speicherbausteines 31, wie beim Ausführungsbeispiel in Figur 1, über Widerstandselemente 21 mit einem gemeinsamen Schaltungsknoten 3 und dieser mit einem der Anschlüsse 2 der Testeranordnung 32 verbunden sind. Ferner wird unterstellt, daß die Widerstandselemente 21 denselben Widerstandswert aufweisen. In den Fällen, in denen an den Ausgängen 1 dasselbe Signal anliegt, stellt sich an den Schaltungsknoten 3 ebenfalls dasselbe Signal ein, ohne daß dabei über die Widerstandselemente 21 ein Strom zwischen den Ausgängen 1 fließt.

In Figur 4 bezeichnet V_{high} die untere Schwelle des Potentialbereiches, in dem ein Signal zum Bewertungszeitpunkt t₁ von der Testeranordnung 32 als logische Eins erkannt wird. V_{low} ist die obere Schwelle desjenigen Bereiches, welchem der logische Null-Wert zugeordnet wird. Zu einem Zeitpunkt t₀ befinden sich die Ausgänge 1 im hochohmigen Zustand (Tristate). Werden sie aktiviert, schwingen sich die Signale an den Ausgängen 1 bis zu einem Zeitpunkt t₁ ein. Der Zeitpunkt t₁ ist der frühestmögliche Bewertungszeitpunkt, zu welchem die an den mit den Schaltungsknoten 3 verbundenen Anschlüsse 2 anliegenden resultierenden Signale S von der Testeranordnung 32 ausgewertet werden können.

Beim Auslesen zuvor beschriebener adressierter Speicherzellen ergeben sich bei intaktem Speicherbaustein 31 zum Bewertungszeitpunkt t₁ an den Ausgängen 1 Signale mit Potentialen, welche größer als V_{high} sind. Diese Signale haben am mit diesen Ausgängen 1 über Widerstandselemente 21 verbundenen Schaltungsknoten 3 und damit am Anschluß 2 resultierende Signale S mit einem Potential V₁ zur Folge, welches ebenfalls größer als V_{high} ist.

Sind dagegen zum Bewertungszeitpunkt t₁ eines oder beide an den Ausgängen 1 mit gemeinsamem Schaltungsknoten 3 anliegenden Signale fehlerhaft, sind ihre Potentiale kleiner als V_{high}. Diese Signale haben am Anschluß 2 ein resultierendes Signal S mit einem Potential V₂ zur Folge, welches ebenfalls unterhalb von V_{high} liegt.

Wird der Speicherbaustein 31 bezüglich des Lesens logischer Null-Werte untersucht, ergibt die Prüfung äquivalent eine ordnungsgemäße Funktion des Speicherbausteines 31, wenn am Schaltungsknoten 3 ein Signal festgestellt wird, welches kleiner als V_{low} ist.

Auf diese Weise läßt sich durch Prüfung des resultierenden Signals S am Schaltungsknoten 3 bzw. am Anschluß 2 die ordnungsgemäße Funktion des Speicherbausteines 31 prüfen.

## Patentansprüche

1. Prüfschaltung (33) zur Funktionsprüfung von elektronischen Schaltungen (31) mit Ausgängen (1),
**dadurch gekennzeichnet,**
daß wenigstens zwei Widerstandselemente (21) einen gemeinsamen Schaltungsknoten (3) aufweisen, welcher mit einem Anschluß (2) einer Testeranordnung (32) verbindbar ist und daß die vom Schaltungsknoten (3) abgewandten Anschlüsse (4) der Widerstandselemente (21) mit jeweils einem Ausgang (1) verbindbar sind.

2. Prüfschaltung (33) gemäß Anspruch 1,
**dadurch gekennzeichnet**,
daß die über die Widerstandselemente (21) mit demselben Schaltungsknoten (3) verbundenen Anschlüsse (1) während der Prüfung in dem Fall, daß die zu prüfende elektronische Schaltung (31) in Ordnung ist, dasselbe Signal aufweisen.

3. Prüfschaltung (33) nach einem der vorstehenden Ansprüche,
**dadurch gekennzeichnet,**
daß sie Bestandteil der elektronischen Schaltung (31) ist.

4. Prüfschaltung (33) nach einem der Ansprüche 1 oder 2,
**dadurch gekennzeichnet,**
daß sie Bestandteil der Testeranordnung (32) ist.

5. Prüfschaltung (33) nach einem der Ansprüche 1 oder 2,
**dadurch gekennzeichnet,**
daß sie auf einer steckbaren Platine (34) angeordnet ist.

6. Prüfschaltung (33) nach einem der vorstehenden Ansprüche,
**dadurch gekennzeichnet,**
daß ein Widerstandselement (21) einen aktiven Widerstand enthält.

7. Prüfschaltung (33) nach Anspruch 6,
**dadurch gekennzeichnet,**
daß das Widerstandselement (21) ein Transistorelement ist.

8. Prüfschaltung (33) nach einem der Ansprüche 1 bis 5,
**dadurch gekennzeichnet,**
daß ein Widerstandselement (21) einen passiven Widerstand enthält.

9. Prüfschaltung (33) nach Anspruch 8,
**dadurch gekennzeichnet,**
daß *das* Widerstandselement (21) ein ohmscher Widerstand ist.

10. Prüfschaltung (33) nach Anspruch 9,
**dadurch gekennzeichnet,**
daß der ohmsche Widerstand (21) einen Wert von 68 Ohm hat.

11. Prüfschaltung (33) nach einem der vorstehenden Ansprüche,
**dadurch gekennzeichnet,**
daß Widerstandselemente (21) mit gemeinsamem Schaltungsknoten (3) denselben Widerstandswert haben.

12. Prüfschaltung (33) nach einem der Ansprüche 1 bis 11,
**dadurch gekennzeichnet,**
daß Widerstandselemente (21) mit gemeinsamem Schaltungsknoten (3) verschiedene Widerstandswerte haben.

13. Prüfschaltung (33) nach einem der vorstehenden Ansprüche,
**dadurch gekennzeichnet,**
daß ein Widerstandselement (21) ein Kurzschlußelement ist.

14. Prüfschaltung (33) nach einem der vorstehenden Ansprüche,
**dadurch gekennzeichnet,**
daß ein Schaltungsknoten (3) über ein weiteres Widerstandselement (22) mit einem festen Potential (41) verbunden ist.

15. Prüfverfahren zur Funktionsprüfung von elektronischen Schaltungen (31) mit Ausgängen (1) mit Hilfe einer Prüfschaltung (33) nach einem der vorstehenden Ansprüche, bei dem die elektronische Schaltung (31) in einen Zustand versetzt wird, in welchem an ihren zu prüfenden Ausgängen (1) Signale anliegen,
**dadurch gekennzeichnet,**
daß die Funktionsprüfung bezüglich eines sich an einem gemeinsamen Schaltungsknoten (3) einstellenden, resultierenden Signals (S) durchgeführt wird.
